# EUROPEAN PATENT APPLICATION

(11) **EP 4 576 181 A1**
(43) Date of publication of application: **25.06.2025**
(21) Application number: 23871542.9
(22) Date of filing: 16.08.2023
(51) Int. Cl.: H01L 21/677, B61B 3/02, B61B 13/06, B65G 1/04

(54) **ROTATION MECHANISM AND CEILING CARRIER**

(30) Priority: 29.09.2022 JP 2022156051
(71) Applicant: Murata Machinery, Ltd., Kyoto-shi, Kyoto 601-8326 (JP)
(72) Inventor: TORAZAWA, Masayoshi, Inuyama-shi, Aichi 484-8502 (JP)
(74) Representative: Weickmann & Weickmann PartmbB
(86) International application number: PCT/JP2023/029635
(87) International publication number: WO 2024/070300

(57) **Abstract**

A rotation mechanism includes: a first portion; and a second portion configured to rotate relatively to the first portion around a rotation axis. Either the first portion or the second portion includes a cylindrical member and a transmission member spirally wound around an outer circumferential surface of the cylindrical member in a winding area exceeding one revolution of the outer circumferential surface. The other of the first portion and the second portion includes a drive unit configured to feed the transmission member. At least one guide member provided on the outer circumferential surface of the cylindrical member, at a position outside the winding area on an extension of at least one of an upper-end portion and a lower-end portion in a circumferential direction, and adjacent to the winding area in a direction of the rotation axis.

## Description

### Technical Field

The present disclosure relates to a rotation mechanism and an overhead transport vehicle.

### Background Art

Conventionally, for example, it is known that an overhead transport vehicle configured to transport an article has a configuration in which a rotation drive unit is provided in a transfer device. For example, in an overhead transport vehicle described in Patent Literature 1, a lateral mechanism and lifting drive unit are rotated by a first rotation drive unit within a range of 270 degrees around a first vertical axis. This allows the transfer position (direction) of an article using the lateral slide movement of the lateral mechanism to be changed within the range of its rotation angle.

### Citation List

### Patent Literature

[Patent Literature 1] International Publication No. WO 2020/090288

### Summary of Invention

### Technical Problem

To rotate a certain portion around a vertical rotation axis by a rotation drive unit, for example, a mechanism is considered in which a transmission member such as a belt is wound around the outer circumferential surface of either a first portion disposed above or a second portion disposed below, and a drive unit configured to feed a transmission member to the other of the first portion and the second portion is further provided. In this case, the transmission member is wound around the outer circumferential surface of either the first portion or the second portion in a spiral manner, for example.

When the transmission member is wound around more than one revolution (in a range exceeding the entire circumference of the outer circumferential surface), one portion of the transmission member and another portion of the transmission member are adjacent to each other in the direction of the rotation axis. When the transmission member is fed by the drive unit, one portion of the transmission member being in contact with the drive unit is once separated from the outer circumferential surface, but then returns again onto the outer circumferential surface. If another portion of the transmission member is present near the one portion of the transmission member that has returned on the outer circumferential surface, the one portion may override the other portion. Such overriding may reduce the rotational accuracy.

The present disclosure describes a rotation mechanism and an overhead transport vehicle that can prevent one portion of a transmission member from overriding another portion.

### Solution to Problem

A rotation mechanism including: a first portion; and a second portion disposed below the first portion and configured to rotate relatively to the first portion around a rotation axis extending in an up-and-down direction. Either the first portion or the second portion includes a cylindrical member disposed concentrically with the rotation axis and a transmission member spirally wound around an outer circumferential surface of the cylindrical member in a winding area exceeding one revolution of the outer circumferential surface of the cylindrical member, the transmission member including an upper-end portion and a lower-end portion fixed to the cylindrical member. The other of the first portion and the second portion includes a drive unit configured to feed the transmission member by applying a driving force to the transmission member. At least one guide member is provided on the outer circumferential surface of the cylindrical member, at a position outside the winding area on an extension of at least one of the upper-end portion and the lower-end portion in a circumferential direction, and adjacent to the winding area in a direction of the rotation axis.

With this rotation mechanism, a rotation of 360 degrees or more can be achieved by winding the transmission member around the outer circumferential surface for more than one revolution. The transmission member is open-ended, and thus is easy to be removed and provides excellent maintainability. Furthermore, at least one guide member is adjacent to the winding area in the direction of the rotation axis. This allows the transmission member to be guided to the winding area by the guide member. Thus, one portion of the transmission member is prevented from overriding another portion. Consequently, rotational accuracy in the rotation mechanism is improved.

The at least one guide member may include a lower guide member disposed at a position outside the winding area on the extension of the lower-end portion in the circumferential direction, and the lower guide member may have an upwardly inclined surface configured to guide upward one portion of the transmission member closer to the upper-end portion. The upwardly inclined surface of the lower guide member smoothly guides the transmission member and can reliably prevent the one portion of the transmission member closer to the upper-end portion from overriding the other portion closer to the lower-end portion.

The at least one guide member may include an upper guide member disposed at a position outside the winding area on the extension of the upper-end portion in the circumferential direction, and the upper guide member may have a downwardly inclined surface configured to guide downward one portion of the transmission member closer to the lower-end portion. The downwardly inclined surface of the upper guide member smoothly guides the transmission member and can reliably prevent the one portion of the transmission member closer to the lower-end portion from overriding the other portion closer to the upper-end portion.

The at least one guide member may be disposed adjacently to at least one of the upper-end portion and the lower-end portion in the circumferential direction. The area where overriding of the transmission member is more likely to occur is an area, of the winding area starting from the upper-end portion or the lower-end portion, closer to the end portion. Thus, this configuration can more reliably prevent overriding of the transmission member.

As another aspect of the present disclosure, an overhead transport vehicle including: a traveling cart including the first portion; and a body section including the second portion and a transfer device attached below the second portion and configured to transfer a transported object may be provided. In this overhead transport vehicle, the transfer device can transfer an article laterally and downward, and further the above-described rotation mechanism allows the body section to rotate around the rotation axis with respect to the traveling cart. In other words, with this overhead transport vehicle, the rotational accuracy (pivoting accuracy) of the body section including the transfer device is improved, and the article can be placed more accurately.

### Advantageous Effects of Invention

According to the present disclosure, one portion of the transmission member is prevented from overriding another portion. Consequently, the rotational accuracy in the rotation mechanism is improved.

### Brief Description of Drawings

[FIG. 1] FIG. 1 is a perspective view illustrating an example of a traveling vehicle system according to an embodiment.
[FIG. 2] FIG. 2 is an exploded perspective view illustrating four rail units that form a rail assembly in FIG. 1 and a coupling member that couples them together.
[FIG. 3] FIG. 3 is a side view illustrating an overhead transport vehicle in FIG. 1.
[FIG. 4] FIG. 4 is a perspective view illustrating the overhead transport vehicle in FIG. 1.
[FIG. 5] FIG. 5 is a perspective view illustrating a first portion of the overhead transport vehicle and a body section attached to the first portion.
[FIG. 6] FIG. 6 is a perspective view illustrating a cylindrical member of the first portion, a transmission member, and a drive unit provided to the second portion, for example.
[FIG. 7] FIG. 7 is a side view of the cylindrical member.
[FIG. 8] FIG. 8 is a diagram illustrating two guide members to be attached to the cylindrical member.
[FIG. 9] FIG. 9(a) is a perspective view of a guide member, FIG. 9(b) is a front view of the guide member, and FIG. 9(c) is a bottom view of the guide member.

### Description of Embodiments

The following describes the embodiments of the present disclosure with reference to the drawings. In the description of the drawings, identical elements are marked with the same symbol and redundant explanations are omitted. In the drawings, for convenience of explanation, each configuration according to the embodiment is represented at a different scale as appropriate. In some drawings, the XYZ Cartesian coordinate system is also shown. In the following description, this coordinate system will be referred to for ease of explanation. Hereafter, one direction along a horizontal plane is an X direction (first direction), a direction orthogonal to the X direction and along the horizontal plane is a Y direction (second direction), and a vertical direction is a Z direction.

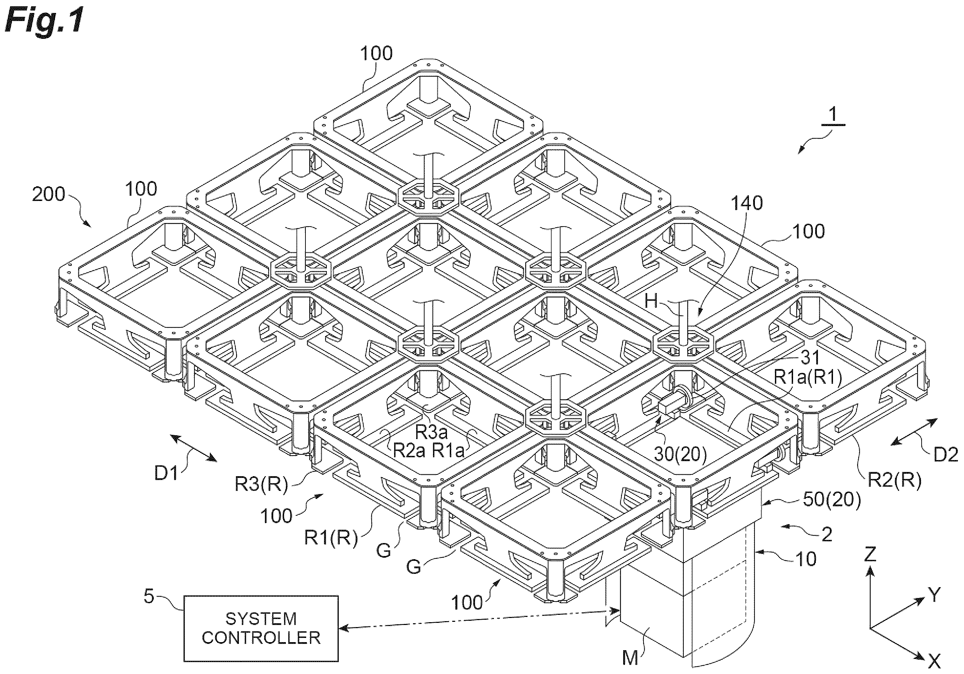

As illustrated in FIG. 1, the overhead vehicle system (traveling vehicle system) 1 according to the embodiment is a grid system (transport system or tracked cart system) for transporting an article M by means of an overhead traveling vehicle 2 in a clean room of a semiconductor manufacturing plant, for example. The overhead vehicle system 1, for example, has a plurality of the overhead traveling vehicles (the overhead transport vehicle) 2 (hereinafter collectively referred to as "traveling vehicles 2"), a system controller 5 configured to control the traveling vehicles 2, and a track R on which a plurality of the traveling vehicles 2 travel. The traveling vehicles 2 move along the track R of the overhead vehicle system 1. The traveling vehicles 2 run along the track R and transport the article M, such as a FOUP (Front Opening Unified Pod) configured to house semiconductor wafers, a reticle Pod configured to house reticles, or the like. The traveling vehicles 2 each may be referred to as a cart, a transport vehicle, a transport cart, a traveling cart, or the like. The traveling vehicles 2 enable high-density transportation of the articles M and increase the transport efficiency of the articles M. The overhead vehicle system 1 may also include only one traveling vehicle 2.

The track R is provided on or near the ceiling of a clean room or other building. The track R is provided adjacent to, for example, processing equipment, a stocker (automatic warehouse), or the like. The processing equipment includes, for example, exposure equipment, coater developers, deposition equipment, etching equipment, or the like, the processing equipment applying various types of processing to the semiconductor wafers in the articles M transported by the traveling vehicles 2. The stocker stores the articles M to be transported by the traveling vehicle 2.

The tracks R are arranged in a grid in plan view. The track R extends along the horizontal direction. In the present embodiment, the track R is constructed by a plurality of rail units 100 each including a first rail R1, a second rail R2, and an intersection rail R3, the rail units 100 being provided side by side in the X direction and in the Y direction. The overhead vehicle system 1 includes the rail units 100 provided side by side in the X direction and in the Y direction, and a plurality of connecting members 140 each configured to connect the rail units 100 to each other. The rail units 100 and the connecting members 140 form a rail assembly 200. The rail assembly 200 is suspended from an unillustrated ceiling or the like by a plurality of hanging members H at portions where the rail units 100 are connected to each other by the connecting members 140.

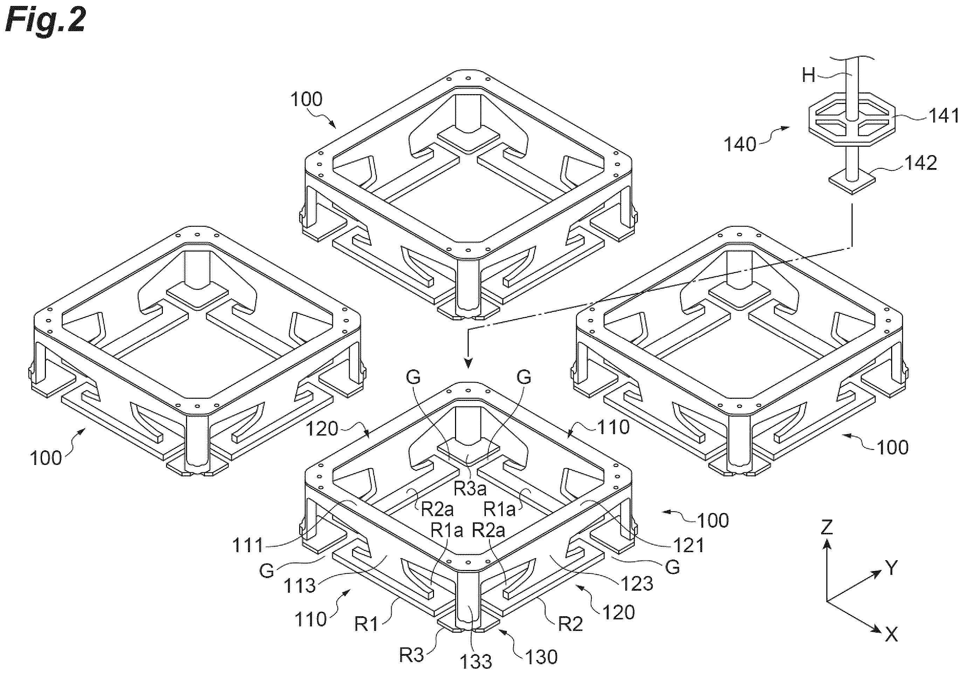

FIG. 2 is an exploded perspective view of the four rail units 100 constituting the rail assembly 200 in FIG. 1 and the connecting member 140 configured to connect those rail units 100. Each of the rail units 100 is a member of a rectangular shape (frame shape) and has the same configuration. Each rail unit 100 includes two first rail members 110 disposed along the X direction, two second rail members 120 disposed along the Y direction, and four intersection rail members 130 disposed such that gaps are formed on extension lines of the first rail member 110 and the second rail member 120 (i.e., at the intersections of the grid). When the rail unit 100 is viewed in plan view, the two parallel first rail members 110 and the two parallel second rail members 120 are disposed in a square shape, and the four intersection rail members 130 are disposed at the apexes of the square.

Each rail unit 100 is made of metal, for example, and is an integrated unit obtained by molding each of the first rail member 110, the second rail member 120, and the intersection rail member 130.. Each of the first rail members 110 includes a first beam portion 111 disposed at an upper end position of the rail unit 100 and extending in the X direction, a first rail R1 disposed at a lower end position of the rail unit 100 and extending in the X direction, and a first support wall 113 disposed between the first beam portion 111 and the first rail R1, and joined to the first beam portion 111 and the first rail R1. Each of the second rail members 120 includes a second beam portion 121 disposed at the upper end position of the rail unit 100 and extending in the Y direction, a second rail R2 disposed at the lower end position of the rail unit 100 and extending in the Y direction, and a second support wall 123 disposed between the second beam portion 121 and the second rail R2 and joined to the second beam portion 121 and the second rail R2. A plurality of the first beam portions 111 and a plurality of the second beam portions 121 form a grid structure, the structure extending along an XY plane at the upper end position of the rail assembly 200. The first support wall 113 extends along the XZ plane. The second support wall 123 extends along the YZ plane.

The intersection rail member 130 includes an intersection support column 133 extending along the Z direction (vertical direction) at the position where the first beam portion 111 and the second beam portion 121 are joined at right angles, and an intersection rail R3 at a lower end of the intersection support column 133.

As illustrated in FIG. 1, a plurality of the first rails R1 each extend along the X direction. A plurality of the second rails R2 each extend along the Y direction. The track R is formed in a grid in plan view by the first rails R1 and the second rails R2. The track R is formed in a plurality of squares by the first rails R1 and the second rails R2. The intersection rail R3 is disposed at a portion corresponding to the intersection between the first rail R1 and the second rail R2. The intersection rail R3 is adjacent to and spaced apart from the first rail R1 in an X direction. The intersection rail R3 is adjacent to and spaced apart from the second rail R2 in the Y direction. The intersection rail R3 is used in every case when the traveling vehicle 2 travels along the first rail R1, when the traveling vehicle 2 travels along the second rail R2, or when the traveling vehicle 2 travels from the first rail R1 to the second rail R2 or from the second rail R2 to the first rail R1.

Each rail unit 100 forms a track R of a square shape (or a rectangular shape) corresponding to a single square in its interior thereof. When the rail units 100 are aligned in the X direction and the Y direction, the first rails R1 extend in a series in the X direction and the second rails R2 extend in a series in the Y direction. The two intersection rails R3 are disposed at intervals between one first rail R1 and another first rail R1 on the X direction line. On the Y direction line, the two intersection rails R3 are disposed at intervals between the one second rail R2 and another second rail R2. The track R is described in another viewpoint. When focusing on the four squares made of two squares aligned in the X direction and two squares aligned in the Y direction, the four intersection rails R3 adjacent to each other in the X direction and the Y direction are disposed at intervals (with respect to the first rail R1) between the two first rails R1 adjacent to each other in the Y direction and another two first rails R1 adjacent to each other in the Y direction. The same four intersection rails R3 as above are disposed at intervals (with respect to the second rail R2) between the two second rails R2 adjust each other in the X direction and another two second rails R2 adjacent to each other in the X direction.

In a rail assembly 200, the first rails R1, the second rails R2, and the intersection rails R3 are disposed at intervals from each other, and thereby a track R is constructed. A gap G corresponding to the above interval is formed between each first rail R1 and the corresponding intersection rail R3. A gap G corresponding to the above interval is formed between each second rail R2 and the corresponding intersection rail R3. The gap G in the track R has a constant size. Each of the first rails R1 includes a first travel surface R1a that is flat and horizontal on its upper surface, and the traveling wheel 31 of the traveling vehicle 2 travels on the first travel surface R1a in the X direction (first traveling direction D1). Each of the second rails R2 includes a second travel surface R2a that is flat and horizontal on its upper surface, and the traveling wheel 31 of the traveling vehicle 2 travels on the second travel surface R2a in the Y direction (second traveling direction D2). The intersection rail R3 includes an intersection travel surface R3a that is flat and horizontal on its upper surface. The heights of the first travel surface R1a, the second travel surface R2a, and the intersection travel surface R3a are equal throughout the entire track R. The first travel surface R1a, the second travel surface R2a, and the intersection travel surface R3a are disposed on the same or substantially the same horizontal plane.

For example, there is no gap having a size of the gap G formed between the four intersection rails R3 described above. When the traveling vehicle 2 passes in a straight line through the rail units 100, the traveling wheel 31 of the traveling vehicle 2 travels on the intersection travel surface R3a. During the traveling, the traveling wheel 31 passes over any two of the four intersection rails R3 described above. Alternatively, when the traveling vehicle 2 changes the traveling direction between the rail units 100 (changes the traveling direction by 90 degrees, i.e., turns), the traveling wheel 31 of the traveling vehicle 2 passes over the intersection travel surface R3a (while changing the direction).

As described above, in the rail assembly 200, the first rail member 110, the second rail member 120, and the intersection rail member 130 constitute the track R in a grid. The layout of the track R configured in a grid in the overhead vehicle system 1 may be adjusted or modified as appropriate by providing the rail units 100 in any desired arrangement (including adding or removing of rail units 100).

Referring to FIG. 2, the connection structure of the rail unit 100 with the connecting member 140 is described. As illustrated in FIG. 2, each of the connecting members 140 includes an upper connecting member 141 and a lower connecting member 142. The upper surface of any one of the four corners of the plurality of (typically four) rail units 100 is attached to an upper connecting member 141 of a plate shape or a frame shape extending horizontally. The upper connecting member 141 is in contact with each of the respective rail units 100 near the intersection of the first beam portion 111 and the second beam portion 121. The lower connecting member 142 of a plate shape or a frame shape extending horizontally supports the lower surface of any one of the four corners of the plurality of (typically four) rail units 100. The lower connecting member 142 is in contact with the intersection rail R3 in each of the rail units 100.

A bar shaped hanging member H extending in the vertical direction passes through the upper connecting member 141 and the lower connecting member 142. The upper connecting member 141 and/or the lower connecting member 142 are fixed to the rail unit 100 by unillustrated fastening members or the like, and thereby the rail units 100 are connected to each other. Note that a space 100e extending in the Z direction is formed between the rail units 100, and a space R3e extending in the Z direction is formed between the four intersection rails R3 adjacent to each other in the X and Y directions (center portion in plan view). The hanging member H is inserted into the space 100e and the space R3e, and the upper connecting member 141 and/or the lower connecting member 142 are fixed to the hanging member H.

The overhead vehicle system 1 includes a communication system (not illustrated). The communication system is used for communication between the traveling vehicle 2 and the system controller 5. The traveling vehicle 2 and the system controller 5 are each communicatively connected via a communication system.

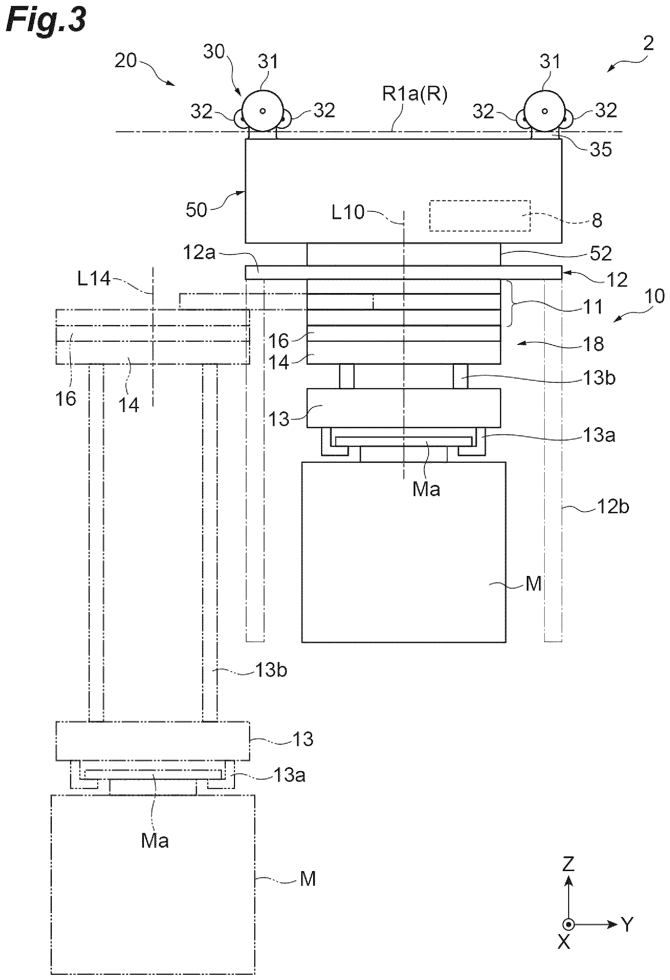

The configuration of the traveling vehicle 2 is then described with reference to FIGs. 1, 3 and 4. As illustrated in FIGs. 1 and 3, the traveling vehicle 2 is provided to be able to travel along the track R. The traveling vehicle 2 has a traveling cart 20 configured to travel on the track R and a body 10 configured to be attached to a bottom part of the traveling cart 20 and can pivot with respect to the traveling cart 20. The traveling cart 20 includes a cart unit 50 of a rectangular shape, for example, disposed below the track R, traveling units 30 provided at the four corner positions of the cart unit 50 in plan view and protruding upward from the cart unit 50, and four wheel-pivoting mechanisms 40 configured to pivot the four traveling wheels 31 in the traveling parts 30, respectively, with respect to the cart unit 50. Inside the cart unit 50, a cart controller (control section) 8 is provided.

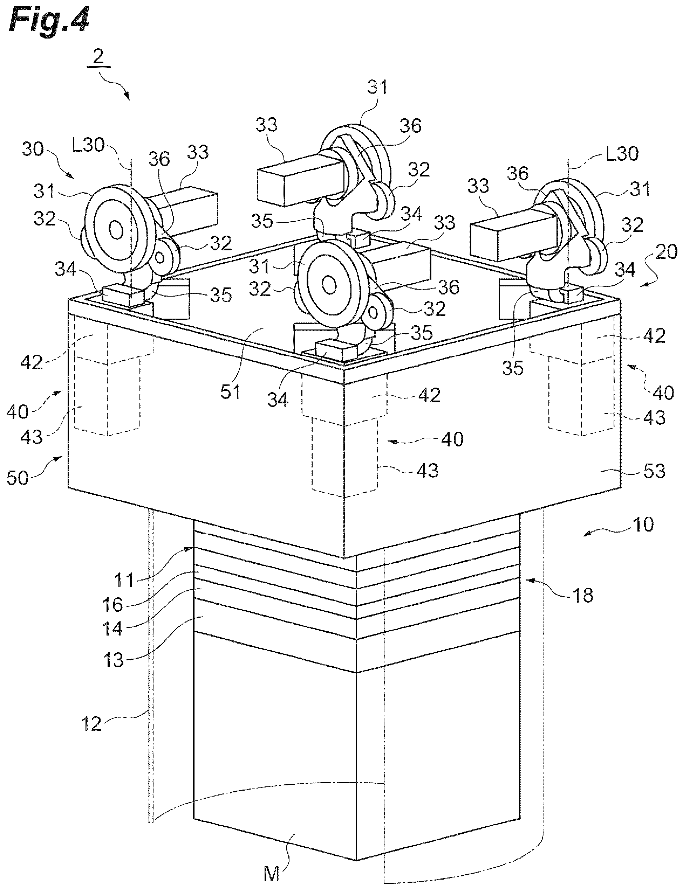

The body 10 is disposed below the track R. As illustrated in FIGs. 3 and 4, the body 10 has a body frame 12 formed in a cylindrical shape, for example. The body frame 12 includes a top panel part 12a of a disc shape and a cylindrical frame 12b hanging from a periphery of the top panel part 12a, and has an open bottom. The body 10 is formed to have dimensions fitting into one square in the track R (see FIG. 1) in plan view. The traveling vehicle 2 can pass another traveling vehicle 2 traveling on the adjacent first rail R1 or the adjacent second rail R2. The body 10 includes a transfer device 18 disposed inside the body frame 12. The transfer device 18 has a rectangular shape in plan view, for example. The cylindrical frame 12b is open in part of a circumferential direction. An area in which an open portion (cutout) is formed is large enough to allow the transfer device 18 to pass through. The transfer device 18, when moving horizontally, passes through the open portion of the cylindrical frame 12b.

The body 10 is attached to the bottom part of the cart unit 50 and can pivot around a rotation axis L10 in the Z direction with respect to the cart unit 50. The traveling wheels 31 at the four corner positions of the cart unit 50 are on the track R (on the first travel surface R1a, the second travel surface R2a, or the intersection travel surface R3a). The cart unit 50 is suspended from the track R via the four traveling wheels 31 and the four wheel-pivoting mechanisms 40. The four traveling wheels 31 allow the cart unit 50 and the body 10 to be suspended stably and the body 10 to travel stably. In other words, the traveling vehicle 2 moves below the track R while being suspended and supported by the traveling wheels 31 traveling along the track R.

The transfer device 18 moves horizontally with respect to the body 10 and transfers the articles M to and from a load port (placing platform). The transfer device 18 is provided below the top panel part 12a of the body frame 12. The body 10 including the transfer device 18 is rotatable around the rotation axis L10 by a drive section (see below for details) provided in the top panel part 12a. The transfer device 18 has an article holding section 13 configured to hold an article M on an underside of the track R, a lifting drive section 14 configured to raise and lower the article holding section 13 in the vertical direction, and a slide mechanism 11 configured to slide the lifting drive section 14 in the horizontal direction. The slide mechanism 11 is held on the lower surface of the top panel part 12a. Between the slide mechanism 11 and the lifting drive section 14, a rotation drive section 16 configured to rotationally drive the lifting drive section 14 with respect to the slide mechanism 11 around the rotation axis L14. The rotation drive section 16 is provided below the slide mechanism 11, and the lifting drive section 14 is provided below the rotation drive section 16. The article holding section 13 is provided below the lifting drive section 14 via a plurality of the hanging members 13b. The load port is a transfer destination or a transfer origin of the traveling vehicle 2 and a point at which the articles M are transferred to or from the traveling vehicle 2.

The article holding section 13 grips a flange part Ma of the article M, thereby holding the article M in a suspended state. The article holding section 13 is, for example, a chuck having a claw part 13a configured to be movable in the horizontal direction. The article holding section 13 advances the claw part 13a below the flange part Ma of the article M to raise the article holding section 13, thereby holding the article M. The article holding section 13 is connected to the hanging members 13b, such as a wire or belt.

The lifting drive section 14 is, for example, a hoist, the hoist lowering the article holding section 13 by unrolling the hanging members 13b and raising the article holding section 13 by reeling in the hanging members 13b. The lifting drive section 14 is controlled by the cart controller 8 to lower or raise the article holding section 13 at a predetermined speed. In addition, the lifting drive section 14 is controlled by the cart controller 8 to hold the article holding section 13 at a target height.

The slide mechanism 11 has a plurality of movable plates disposed on top of each other in the Z direction, for example. By rotating the body 10, the slide mechanism 11 moves the rotation drive section 16, the lifting drive section 14, and the article holding section 13 attached to the lowest movable plate in any desired direction in the horizontal plane. The Rotation angle of the body 10 with respect to the cart unit 50 determines the direction of movement of the movable plate in the slide mechanism 11. In the body 10, the orientation of the transfer device 18 and the body frame 12 is set such that the direction of movement of the movable plate and the position of the open portion of the cylindrical frame 12b coincide.

The rotation drive section 16 includes, for example, an electric motor or the like and rotates the lifting drive section 14 (and the article holding section 13) within a predetermined angular range around a rotation axis L14 extending in the vertical direction. The angle at which rotation can be performed by the rotation drive section 16 is any desired angle smaller than or equal to 180 degrees, for example, but the upper limit is not limited to 180 degrees. The rotation drive section 16 allows the article holding section 13 (or the article M held by the article holding section 13) held out sideways to be oriented in any desired direction. The slide mechanism 11 and the rotation drive section 16 are controlled by the cart controller 8. Note that even when the movable plates of the slide mechanism 11 have not moved and are stowed (in a state indicated by the solid line in FIG. 3), the lifting drive section 14 can be rotated by the rotation drive section 16. In that case, for example, the rotation axis L14 of the lifting drive section 14 coincides with the rotation axis L10 of the body 10.

The cart unit 50 has a support member 52 of a cylindrical shape (cylindrical member) at the lower end. The top panel part 12a of the body frame 12 is attached in a rotatable manner to the lower surface side of the support member 52. For example, a drive section (see below for details), such as an electric motor, is provided in the top panel part 12a. The driving force of the rotation drive section is transmitted to the support member 52, and thereby the body frame 12 rotates around the rotation axis L10 extending in the vertical direction with respective to the cart unit 50. The angle at which the body frame 12 is rotatable is any desired angle between 360 degrees and 540 degrees, for example, but the upper limit is not limited to 540 degrees. The slide mechanism 11 is attached to the lower surface side of the top panel part 12a, and the top panel part 12a supports the slide mechanism 11. The body frame 12 and the transfer device 18 are integrated, and the body frame 12 and the transfer device 18 rotate together. The traveling vehicle 2 can receive and deliver the article M to the load port by using the transfer device 18.

Note that an unillustrated cover may be attached to an outer surface side of the cylindrical frame 12b. In that case, the cover encloses the transfer device 18 and the article M held in the transfer device 18. The cover has a cylindrical shape with an open bottom end and has a cutout (the open portion described above)where the movable plates of the slide mechanism 11 protrude.

The traveling part 30 has four traveling wheels 31. Each of the traveling wheels 31 is provided with two auxiliary wheels 32. As illustrated in FIG. 4, the traveling wheels 31 are provided at the four corner positions of the cart unit 50 to protrude upward from the upper surface cover 51. Each of the traveling wheels 31 is rotatable around the horizontal or nearly horizontal axle along the XY plane. On a rotation shaft of each of the traveling wheels 31, a traveling drive motor 33 is provided. Each of the traveling wheels 31 is rotationally driven by the driving force of the traveling drive motor 33. The traveling drive motor 33, for example, is configured to be switchable between forward rotation and reverse rotation. Each of the traveling wheels 31 rolls on the track R. Each of the traveling wheels 31 rolls on the travel surfaces R1a, R2a, and R3a of the first rail R1, second rail R2, and intersection rail R3 to drive the traveling vehicle 2. It is not limited to the configuration that all of the four traveling wheels 31 are rotationally driven by the driving force of the traveling drive motor 33, but a configuration in which only some of the four traveling wheels 31 are rotationally driven may be provided as well.

The four wheel-pivoting mechanisms 40 are fixed to an unillustrated cart frame inside the cart unit 50, and a base part 34 is connected to each of the wheel-pivoting mechanisms 40 via a pivoting shaft of the wheel-pivoting mechanism 40. On the base part 34, the traveling wheel 31, the two auxiliary wheels 32, and the respective traveling drive motor 33 are attached via a connecting part 35 and a support member 36. For example, an upper surface cover 51 of a square shape is provided on the upper surface of a housing 53, and the base parts 34 are disposed in cutouts formed in the four corners of the upper surface cover 51. The connecting part 35, the traveling wheels 31, the auxiliary wheels 32, and the traveling drive motor 33 are disposed above the upper surface cover 51.

As illustrated in FIGs. 3 and 4, the connecting part 35 connects the cart unit 50 (in detail, the wheel-pivoting mechanism 40 fixed in the cart unit 50) to the traveling wheels 31. With this connection structure, the cart unit 50 and the body 10 are disposed below the track R and suspended from the traveling part 30. The connecting part 35 is formed to be thick enough to pass through the gaps G between the first rail R1 and the intersection rail R3, and between the second rail R2 and the intersection rail R3. The support member 36 is provided in the top part of the connecting part 35 and supports in a rotatable manner the rotation shaft of the traveling wheel 31 and a respective rotation shaft of the auxiliary wheels 32. The support member 36 maintains a relative position of the traveling wheel 31 and the auxiliary wheel 32.

As illustrated in FIG. 4, the traveling wheels 31 are provided in a rotatable manner around a rotation axis L30 extending in the vertical direction. The four rotation axes L30 are disposed at the apexes of a square in plan view, and the rotation axis L10 is placed at the center between the rotation axes L30. In other words, the four rotation axes L30 are disposed at positions that are four-fold symmetrical positions with respect to the rotation axis L10 of the body 10. In plan view, the position of the traveling wheel 31 is different (displaced) from the position of the rotation axis L30. The traveling wheels 31 are turned by the wheel-pivoting mechanism 40, so that the traveling direction of the traveling vehicle 2 can be changed.

The auxiliary wheels 32 are disposed such that one is dispose in front of and the other is disposed behind the traveling wheel 31 in the traveling direction. Each of the auxiliary wheels 32 is rotatable around the axis of a horizontal or nearly horizontal axle along the XY plane. The lower ends of the auxiliary wheels 32 are set higher than the lower end of the traveling wheel 31, for example. Therefore, when the traveling wheels 31 are traveling on the travel surfaces R1a, R2a, and R3a, the auxiliary wheels 32 do not contact the travel surfaces R1a, R2a, and R3a. In addition, when the traveling wheels 31 pass through the gaps G between the first rail R1 and the intersection rail R3, and between the second rail R2 and the intersection rail R3, the auxiliary wheels 32 contact unillustrated auxiliary members provided on the first rail R1 and the second rail R2 to prevent the traveling wheels 31 from falling. The configuration is not limited to providing two auxiliary wheels 32 for one traveling wheel 31. For example, one auxiliary wheel 32 may be provided for one traveling wheel 31 or no auxiliary wheel 32 may be provided.

The four wheel-pivoting mechanisms 40 are disposed, for example, at the four corner positions in the housing 53 of the cart unit 50. Each of the wheel-pivoting mechanism 40 has a steering motor 43, and a drive force transmission section 42 provided between the steering motor 43 and the traveling wheel 31. The drive force transmission section 42 is fixed to an unillustrated cart frame inside the cart unit 50. The drive force transmission section 42 is connected to the base part 34 via a pivoting shaft. Each of the wheel-pivoting mechanisms 40 rotates the base part 34, the connecting part 35, the support member 36, the traveling wheel 31, the auxiliary wheel 32, and the traveling drive motor 33 in unison around the rotation axis L30. In a state where the traveling vehicle 2 is positioned in the center of each rail unit 100, each of the traveling wheels 31 is rotated 90 degrees around the corresponding rotation axis L30. Consequently, the traveling wheels 31 turns on the intersection rail R3. Consequently, the traveling vehicle 2 can turn. To turn is to switch from a first state in which the traveling vehicle 2 travels in the first travel direction D1 to a second state in which the traveling vehicle 2 travels in the second travel direction D2, or from the second state in which the traveling vehicle 2 travels in the second travel direction D2 to the first state in which the traveling vehicle 2 travels in the first travel direction D1. A turn of the traveling vehicle 2 is performed, for example, when the traveling vehicle 2 is at a standstill. The turn of the traveling vehicle 2 may be performed with the traveling vehicle 2 stopped but the articles M moving (for example, rotating). The drive of the wheel-pivoting mechanism 40 is controlled by the cart controller 8.

As described above, gaps G are formed in the track R. When the traveling vehicle 2 travels on the first rail R1 and crosses the second rail R2, or when the traveling vehicle 2 travels on the second rail R2 and crosses the first rail R1, a part of the traveling vehicle 2 (in detail, for example, the connecting part 35) passes through the respective gap G.

Note that a guide roller being in contact with a side of the intersection rail R3 may be provided between the traveling wheel 31 and the wheel-pivoting mechanism 40 (for example, near the connecting part 35)e. The guide roller prevents misalignment of the traveling cart 20 (traveling vehicle 2) with respect to the track R.

The traveling vehicle 2 includes an unillustrated position detection section configured to detect position information. The position detection section detects the current position of the traveling vehicle 2 by, for example, detecting position markers on the track R indicating position information. The position detection section detects position markers in a non-contact manner.

The cart controller 8 controls the traveling vehicle 2 in a comprehensive manner. The cart controller 8 is a computer including a CPU (Central Processing Unit), ROM (Read Only Memory) and RAM (Random Access Memory), and the like. The cart controller 8 can be configured as software, for example, with which a computer program stored in ROM is loaded onto RAM and executed by the CPU. The cart controller 8 may be configured as hardware using an electronic circuit or the like. The cart controller 8 may include only a single device or include a plurality of devices. If the system includes a plurality of devices, connecting those devices via a communication network, such as the Internet or an intranet logically constructs a single cart controller 8. The cart controller 8 is installed in the cart unit 50, for example.

The cart controller 8 controls the traveling of the traveling vehicle 2 based on transport instructions. The cart controller 8 controls the traveling of the traveling vehicle 2 by controlling the traveling drive motor 33 and the steering motor 43, and the like. The cart controller 8 controls, for example, travel speed, operations related to stopping, and operations related to direction changes. The cart controller 8 controls the transfer operation of the traveling vehicle 2 based on the transfer instructions. The cart controller 8 controls the pivoting (rotation) of the body 10 (the body frame 12 and the transfer device 18), and thereby controls the transfer direction of the transfer device 18. The cart controller 8 controls the transfer operation of the traveling vehicle 2 by controlling the transfer device 18 and the like. The cart controller 8 controls the operation of gripping the article M to be disposed at a specified load port, and the operation of unloading the held article M down to a specified load port.

The system controller 5 is a computer including a CPU, ROM and RAM, and the like. The system controller 5 can be configured as software, for example, with which a computer program stored in ROM is loaded onto RAM and executed by the CPU. The system controller 5 may be configured as hardware using an electronic circuit or the like. The system controller 5 may include only a single device or include a plurality of devices. If the system controller 5 includes a plurality of devices, connecting those devices via a communication network, such as the Internet or an intranet logically constructs a single system controller 5. At least some of various controls of the system controller 5 may be performed by the cart controller 8.

The system controller 5 selects any of the traveling vehicles 2 configured to be able to transport the articles M and assigns the transport instructions to the selected traveling vehicle 2. The transport instructions include a travel instruction causing the traveling vehicle 2 to travel to the load port, and an instruction to grab the articles M disposed at the load port or an instruction to unload the articles M being held to the load port.

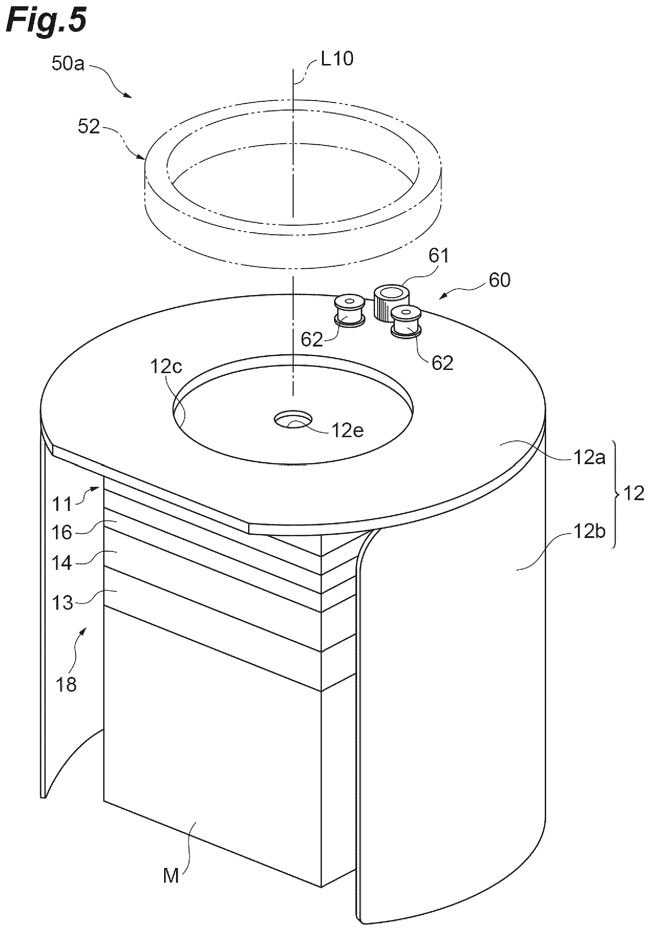

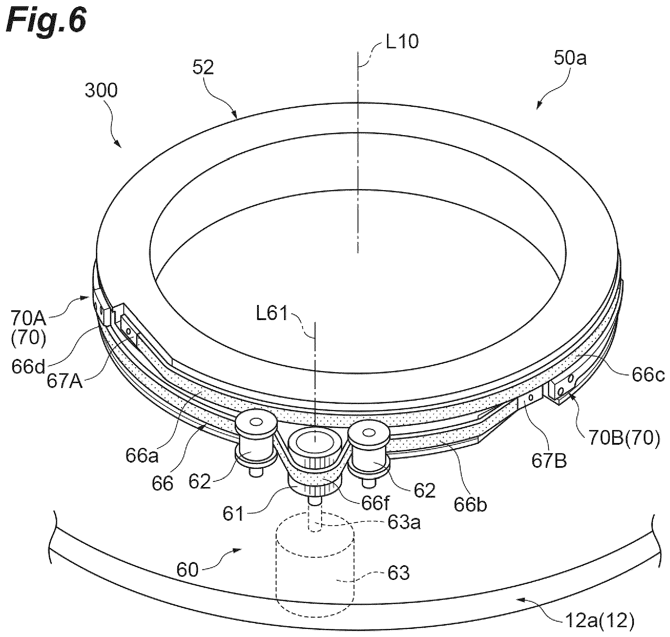

The following specifically describes a mechanism included by the traveling vehicle 2 and configured to rotate (pivot) the body section 10 with reference to FIGS. 5 and 6. The traveling vehicle 2 includes a rotation mechanism 300 (see Fig. 6) configured to rotate the body section 10. The rotation mechanism 300 includes: a cart-frame lower portion (first portion) 50a that is a portion of the cart unit 50; and the body frame (second portion) 12 disposed below the cart-frame lower portion 50a. The rotation mechanism 300 is a mechanism configured to rotate the body frame 12 relatively to the cart-frame lower portion 50a. The body frame 12 rotates relatively to the cart-frame lower portion 50a around the rotation axis L10 extending in an up-and-down direction.

As illustrated in FIG. 5, the cart-frame lower portion 50a includes the support member (cylindrical member) 52 forming the lower end of the cart frame. The support member 52 is disposed concentrically with the rotation axis L10. The top plate 12a of the body frame 12 extending horizontally has, for example, a circular recessed portion 12c formed concentrically with the rotation axis L10 and a central hole 12e formed in the center of the recessed portion 12c (where the rotation axis L10 passes through). The cart frame and the top plate 12a are coupled by a shaft body passing through the central hole 12e, for example. Furthermore, for the top plate 12a to rotate around the rotation axis L10 with respect to the support member 52, a guiding member (e.g., a protrusion) is provided on either the support member 52 or the top plate 12a, and a guided portion (e.g., a recess) is provided on the other of the support member 52 and the top plate 12a. For example, a portion of the cart-frame lower portion 50a may fit into the recessed portion 12c. With the configuration thus exemplified, the body frame 12 is rotatably provided in a manner suspended from the cart-frame lower portion 50a.

As illustrated in FIG. 6, the cart-frame lower portion 50a includes a transmission member 66 wound around an outer circumferential surface 52a of the support member 52. The transmission member 66 is, for example, a belt having a flat cross-section. The cross-section of the transmission member 66 is long in the direction along the rotation axis L10 and short in the radial direction centered on the rotation axis L10. That is, the long-side direction of the cross-section of the transmission member 66 is parallel to the rotation axis L10, and the short-side direction (thickness direction) of the cross-section of the transmission member 66 is parallel to the above-described radial direction. The transmission member 66 is spirally wound around the outer circumferential surface 52a in a range exceeding one revolution thereof.

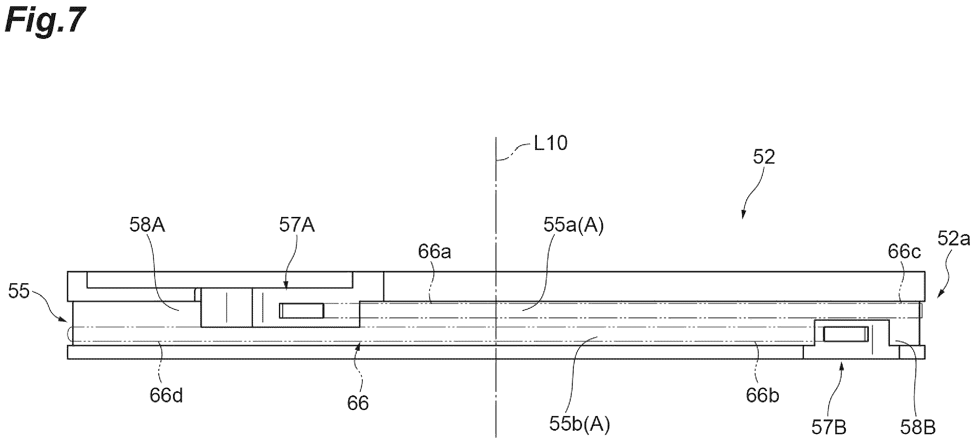

Further details will be described with reference to FIG. 7. FIG. 7 is a side view of the support member 52. As illustrated in FIG. 7, on the entire circumference of the outer circumferential surface 52a of the support member 52, a groove-shaped portion 55 is formed. The transmission member 66 is disposed in this groove-shaped portion 55. As illustrated in FIGS. 6 and 7, on the outer circumferential surface 52a, an upper fixing groove 57A for fixing an upper-end portion 67A of the transmission member 66 and a lower fixing groove 57B for fixing a lower-end portion 67B of the transmission member 66 are formed. Both the upper fixing groove 57A and the lower fixing groove 57B are formed in midpoints of the groove-shaped portion 55. The upper fixing groove 57A and the lower fixing groove 57B, for example, differ in position in the circumferential direction and also differ in position in the direction of the rotation axis L10. In the direction of the rotation axis L10, the upper fixing groove 57A is formed in an upper part of the outer circumferential surface 52a, and the lower fixing groove 57B is formed in a lower part of the outer circumferential surface 52a.

As illustrated in FIG. 6, the upper-end portion 67A of the transmission member 66 is disposed in the upper part of the outer circumferential surface 52a, and the lower-end portion 67B of the transmission member 66 is disposed in the lower part of the outer circumferential surface 52a. The transmission member 66 is wound around the outer circumferential surface 52a for a length of one revolution (360 degrees) plus a predetermined angular range (e.g., 60 to 90 degrees). The predetermined angular range is a range where sections of the transmission member 66 overlap each other in plan view (when viewed from the direction of the rotation axis L10). Within this range, the sections of the transmission member 66 are aligned in substantially parallel rows. The predetermined angular range may be less than 180 degrees, but may be 180 degrees or more. The transmission member 66 is spirally wound in a winding area A extending in a range of one revolution and about one-third to one-half revolution (less than two revolutions in total) from the upper-end portion 67A (upper fixing groove 57A) toward the lower-end portion 67B (lower fixing groove 57B). In other words, the winding area A is a spiral area connecting the upper fixing groove 57A and the lower fixing groove 57B, and is essentially (in the normal state) an area through which the transmission member 66 passes.

As illustrated in FIG. 7, the winding area A includes an upper edge 55a where a portion 66a of the transmission member 66 closer to the upper-end portion 67A is disposed. The winding area A also includes a lower edge 55b where a portion 66b of the transmission member 66 closer to the lower-end portion 67B is disposed. The upper edge 55a and the lower edge 55b are vertically adjacent in the direction of the rotation axis L10. The winding area A includes a single arcuate inclined portion (most of which is hidden behind in FIG. 7) connecting the upper edge 55a and the lower edge 55b. Herein, since the transmission member 66 is spirally wound, the upper edge 55a and the lower edge 55b are also slightly inclined in a spiral manner. The groove-shaped portion 55 of the outer circumferential surface 52a described above has a height (length in the direction of the rotation axis L10) slightly greater than twice the length, in the long-side direction, of the cross-section of the transmission member 66. By this configuration, in the range where the upper edge 55a and the lower edge 55b are adjacent to each other, that is, the range where the sections of the transmission member 66 are aligned in parallel rows, the gap between the rows of the transmission member 66 is shorter than the length, in the long-side direction, of the cross-section of the transmission member 66.

As illustrated in FIG. 6, the body frame 12 includes a drive unit 60 configured to feed the transmission member 66 by applying a driving force to the transmission member 66. For example, the diameter of the top plate 12a is larger than the diameter of the support member 52 (see FIG. 5). The drive unit 60 is disposed outside the support member 52 in the radial direction, for example. The drive unit 60 includes a drive motor 63 attached on the back side of the top plate 12a, one drive pulley 61 fixed to a drive shaft 63a of the drive motor 63, and a pair of auxiliary rollers 62 provided on both sides of the drive pulley 61. Teeth are formed on the entire area of the back surface of the transmission member 66 (the surface being in contact with the outer circumferential surface 52a, i.e., the surface facing inward in the radial direction). The transmission member 66 is a timing belt. On the outer circumferential surface of the drive pulley 61, teeth configured to mesh with the teeth of the transmission member 66 are formed. The drive pulley 61 is a timing pulley. A portion of the transmission member 66 is drawn out and this drawn-out portion 66f is wound around the drive pulley 61. The pair of auxiliary rollers 62 hold bases of the drawn-out portion 66f. The rotation axis L61 of the drive pulley 61 is parallel to the rotation axis L10, for example. The rotation axes of the pair of auxiliary rollers 62 are also parallel to the rotation axis L10. The drive shaft 63a passes through the top plate 12a in a manner rotatable with respect to the top plate 12a. The drive motor 63 is controlled by the cart controller 8. The drive unit 60 feeds the transmission member 66 in a circumferential direction (strictly, in a direction along the spiral) by the rotational driving force of the drive motor 63 and drive pulley 61.

In the rotation mechanism 300, the drive pulley 61 rotates around the rotation axis L61, whereby the transmission member 66 is reeled in and the body frame 12 is rotated with respect to the cart-frame lower portion 50a.

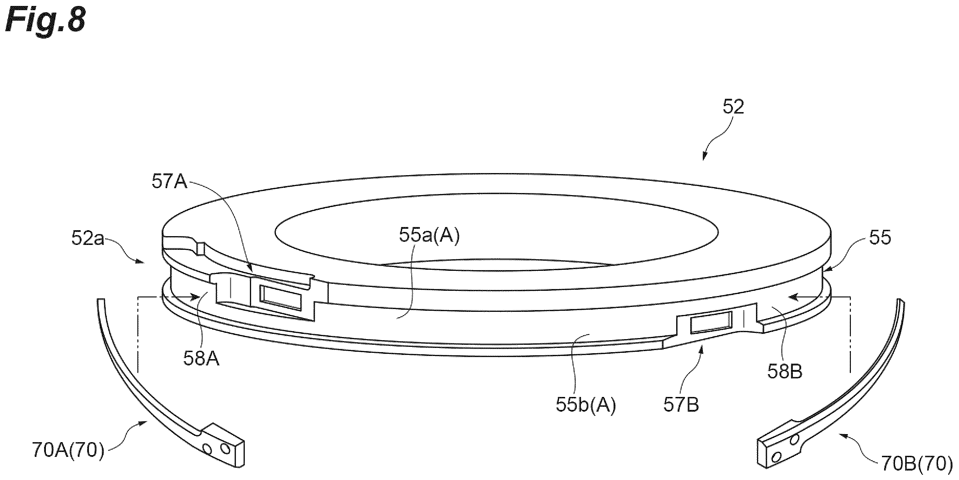

As illustrated in FIGS. 6 to 8, two guide members 70 are fixed to the outer circumferential surface 52a of the support member 52. An upper guide member 70A that is one guide member 70 is disposed at a position (on an upper attachment portion 58A at the left of the upper fixing groove 57A illustrated in FIG. 8) outside the winding area A on the extension of the upper-end portion 67A in the circumferential direction. A lower guide member 70B that is the other guide member 70 is disposed at a position (on a lower attachment portion 58B at the right of the lower fixing groove 57B illustrated in FIG. 8) outside the winding area A on the extension of the lower-end portion 67B in the circumferential direction. In this manner, the upper guide member 70A and the lower guide member 70B are each attached at the respective positions of the outer circumferential surface 52a outside the spirally formed winding area A.

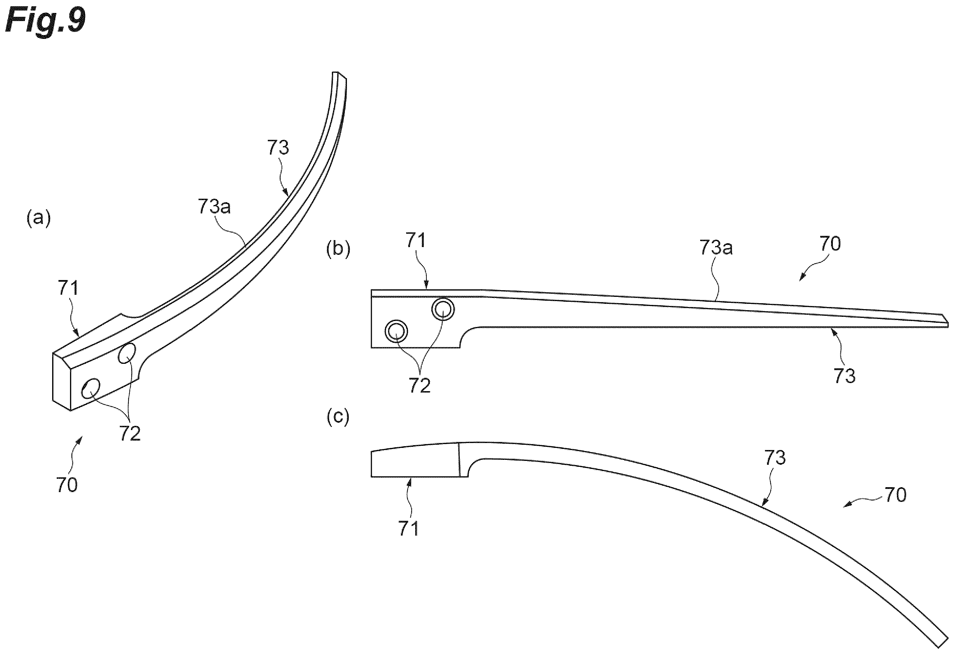

As illustrated in FIG. 6, an inclined surface 73a of the upper guide member 70A (see FIG. 9) is provided to be in contact with the upper surface of one portion 66d of the transmission member 66 in the direction of the rotation axis L10. An inclined surface 73a of the lower guide member 70B is provided to be in contact with the lower surface of one portion 66c of the transmission member 66 in the direction of the rotation axis L10.

As illustrated in FIG. 8, a guide members 70 that is common (identical) component is used as the upper guide member 70A and the lower guide member 70B. However, the orientations in which they are attached on the outer circumferential surface 52a are different. As illustrated in FIGS. 9(a) and 9(c), the upper guide member 70A includes a fixing portion 71 formed in one end thereof and a guiding portion 73 extending in a circular arc manner from the fixing portion 71. In the fixing portion 71, for example, two holes 72 are formed. With these holes 72 and screws (not illustrated), for example, the fixing portion 71 is fixed to the upper fixing groove 57A or the lower fixing groove 57B. The curvature radius of the guiding portion 73 is approximately equal to the curvature radius of the outer circumferential surface 52a of the support member 52 (the bottom surface of the groove-shaped portion 55), and thus the guiding portion 73 extends along the support member 52 (the bottom surface of the groove-shaped portion 55).

As illustrated in FIGS. 6 and 8, the upper guide member 70A is disposed adjacently to the upper-end portion 67A in the circumferential direction. The lower guide member 70B is disposed adjacently to the lower-end portion 67B in the circumferential direction. In order to dispose the respective guide members 70 close to end portions of the transmission member 66 in this manner, portions to which the respective guide members 70 are attached are set in the same areas (or in areas close to each other) as those of the portions to which the upper-end portion 67A and the lower-end portion 67B are attached (fixed portions). More specifically, in the upper fixing groove 57A, recesses and/or holes for fixing the upper-end portion 67A of the transmission member 66 are formed, and also recesses and/or holes for fixing the fixing portion 71 of the upper guide member 70A are formed. In the lower fixing groove 57B, recesses and/or holes for fixing the lower-end portion 67B of the transmission member 66 are formed, and also recesses and/or holes for fixing the fixing portion 71 of the lower guide member 70B are formed. The upper fixing groove 57A and the lower fixing groove 57B each may be flattened for the transmission member 66 and guide members 70 to be easily fixed. Consequently, the guiding portion 73 of the upper guide member 70A is disposed on the upper attachment portion 58A adjacent to the upper fixing groove 57A, and the guiding portion 73 of the lower guide member 70B is disposed on the lower attachment portion 58B adjacent to the lower fixing groove 57B.

As illustrated in FIG. 9(b), an inclined surface 73a is formed on one end surface of the guiding portion 73 of each guide member 70 in the direction of the rotation axis L10 (see FIG. 6), the height position of which changes gradually in the direction of the rotation axis L10. That is, as illustrated in FIG. 6, the upper guide member 70A includes an inclined surface 73a (downwardly inclined surface) configured to guide downward the one portion 66d of the transmission member 66 closer to the lower-end portion 67B. The lower guide member 70B includes an inclined surface 73a (upwardly inclined surface) configured to guide upward the one portion 66c of the transmission member 66 closer to the upper-end portion 67A. Herein, using the term "portion closer to "something"" such as "one portion 66d closer to the lower-end portion 67B" or "one portion 66c closer to the upper-end portion 67A" indicates that the portion is located at a position closer to either end portion. In other words, "closer to "something"" means "relatively close to "something"".

The upper guide member 70A prevents the one portion 66d from overriding the other portion 66a when the one portion 66d comes into contact with the outer circumferential surface 52a after the drive pulley 61 has reeled up the one portion 66d of the transmission member 66. The lower guide member 70B also prevents the one portion 66c from overriding the other portion 66b when the one portion 66c comes into contact with the outer circumferential surface 52a after the drive pulley 61 has reeled up the one portion 66c of the transmission member 66. By this configuration, the transmission member 66 is guided (when coming into contact therewith) such that the transmission member 66, the upper-end portion 67A, the lower-end portion 67B, and the respective portions of the transmission member 66 are aligned in their normal positions without overlapping each other.

With the rotation mechanism 300 according to the present embodiment, a rotation of 360 degrees or more can be achieved by winding the transmission member 66 around the outer circumferential surface 52a for more than one revolution. The transmission member 66 is open-ended, and thus is easy to be removed and provides excellent maintainability. Furthermore, at least one guide member 70 is adjacent to the winding area A in the direction of the rotation axis L10. This allows the transmission member 66 to be guided to the winding area A by the guide member 70. Thus, one portion of the transmission member 66 is prevented from overriding another portion. Consequently, misalignment in the rotation mechanism 300 is prevented and rotational accuracy is improved. The transmission member 66 is open-ended, and thus replacement or adjustment, for example, of the transmission member 66 can be made simply by releasing the fixation at the upper-end portion 67A and the lower-end portion 67B located at both ends. This facilitates replacement, adjustment, or other operations of the transmission member 66, thereby providing excellent maintainability. With the rotation mechanism 300, the transmission member 66 is fed to the extent of exceeding one revolution of the outer circumferential surface 52a of the support member 52, which allows rotation by the drive unit 60. Thus, the rotation (relative rotation) of more than 360 degrees can be achieved.

The lower guide member 70B includes the inclined surface 73a (upwardly inclined surface) configured to guide upward the one portion 66c of the transmission member 66 closer to the upper-end portion 67A. The inclined surface 73a of the lower guide member 70B smoothly guides the transmission member 66 and can reliably prevent the one portion 66c of the transmission member 66 closer to the upper-end portion 67A from overriding the other portion 66b closer to the lower-end portion 67B.

The upper guide member 70A includes the inclined surface 73a (downwardly inclined surface) configured to guide downward the one portion 66d of the transmission member 66 closer to the lower-end portion 67B. The inclined surface 73a of the upper guide member 70A smoothly guides the transmission member 66 and can reliably prevent the one portion 66d closer to the lower-end portion 67B of the transmission member 66 from overriding the other portion 66a closer to the upper-end portion 67A.

The upper guide member 70A and the lower guide member 70B are disposed adjacently to the upper-end portion 67A and the lower-end portion 67B, respectively, in the circumferential direction. The area where overriding of the transmission member 66 is more likely to occur is an area, of the winding area A starting from the upper-end portion 67A or the lower-end portion 67B, closer to the end portion. Thus, this configuration more reliably prevents overriding of the transmission member 66.

In the traveling vehicle 2 of the overhead traveling vehicle system 1, the transfer device 18 can transfer an article M laterally and downward, and further the rotation mechanism 300 allows the body section 10 to rotate around the rotation axis L10 with respect to the traveling cart 20. In other words, with this traveling vehicle 2, the rotational accuracy (pivoting accuracy) of the body section 10 including the transfer device 18 is improved, and the article M can be placed more accurately. The prevention of overriding also reduces the variation in the trajectory of the transmission member 66 in the rotation of the body section 10 and contributes to improving the stopping accuracy.

The embodiment of the present disclosure has been described above, but the present invention is not limited to the embodiment described above. The upper guide member 70A is not limited to the form of being disposed adjacently to the upper-end portion 67A, and may be spaced apart from the upper-end portion 67A in the circumferential direction. The lower guide member 70B is not limited to the form of being disposed adjacently to the lower-end portion 67B, and may be spaced apart from the lower-end portion 67B in the circumferential direction. For example, either the upper guide member 70A or the lower guide member 70B may be omitted. Even in such a modification, the guide member 70 is disposed in a position outside the winding area A (a position through which the spiral transmission member 66 does not essentially pass).

In each guide member 70, the inclined-surface portion may be omitted. The specific configuration of the guide member is not limited to the above embodiment. For example, the guide member can be made in a shape not extending long in the shape of a circular arc.

In the above embodiment, an example has been described in which the rotation axis L61 of the drive pulley 61 extends in the vertical direction. However, the rotation axis L61 of the drive pulley 61 may be tilted to match the inclination of the transmission member 66. By this configuration, slippage of the transmission member 66 on the drive pulley 61 can be reduced, and wear of the transmission member 66 can be reduced. The transmission member is not limited to the belt.

A rotation mechanism may allow the first portion disposed above to rotate with respect to the second portion disposed below. In the above embodiment, the cart-frame lower portion 50a being the first portion includes the support member 52 that is the cylindrical member and the transmission member 66, and the body frame 12 being the second portion includes the drive unit 60. Instead of this configuration, a configuration may be used in which the second portion disposed below includes the cylindrical member and the transmission member and the first portion disposed above includes the drive unit. In this case, the second portion may rotate with respect to the first portion, and the first portion may rotate with respect to the second portion. In these modifications, the same mechanisms and the like as in the above embodiments can be used as specific mechanisms.

In the above embodiment, a case has been described in which the four rotation axes L30 in the traveling unit 30 and the wheel-pivoting mechanism 40 are arranged at the vertexes of a square in plan view. However, the arrangement of the rotation axes L30 does not have to be square-shaped. In plan view, the positions of the traveling wheels 31 may coincide with the positions of the rotation axes L30.

In the above embodiment, a case in which the traveling wheels 31 rotate on the intersection rails R3 has been described. However, each traveling wheel 31 may move from the first traveling surface R1a to the second traveling surface R2a or from the second traveling surface R2a to the first traveling surface R1a when being pivoted by the corresponding wheel-pivoting mechanism 40.

In the above embodiment, a case in which the traveling vehicle is an overhead transport vehicle has been described. However, the traveling vehicle may be a tracked cart configured to travel on a rail (track) installed on the ground.

In the above embodiment, a grid system is used as the overhead traveling vehicle system 1. However, the overhead traveling vehicle system 1 is not limited to the grid system. For example, automated guided vehicles (AGVs) may be used as the transport system, or various known systems configured to travel on a grid-patterned travel path may be used. In the above embodiment, the traveling vehicle 2 holds an article M below the track R. However, the traveling vehicle 2 may hold the article M above the track R.

The structural features of one aspect of the present invention are described as follows.
[1] A rotation mechanism comprising:
   a first portion; and
   a second portion disposed below the first portion and configured to rotate relatively to the first portion around a rotation axis extending in a vertical direction, wherein
   either the first portion or the second portion includes:
      a cylindrical member disposed concentrically with the rotation axis; and
      a transmission member spirally wound around an outer circumferential surface of the cylindrical member in a winding area exceeding one revolution of the outer circumferential surface, the transmission member including an upper-end portion and a lower-end portion fixed to the cylindrical member,
   the other of the first portion and the second portion includes a drive unit configured to feed the transmission member by applying a driving force to the transmission member, and
   at least one guide member is provided on the outer circumferential surface of the cylindrical member, at a position outside the winding area on an extension of at least one of the upper-end portion and the lower-end portion in a circumferential direction, and adjacent to the winding area in a direction of the rotation axis.
[2] The rotation mechanism according to [1], wherein
   the at least one guide member includes a lower guide member disposed at a position outside the winding area on the extension of the lower-end portion in the circumferential direction, and
   the lower guide member has an upwardly inclined surface configured to guide upward one portion of the transmission member closer to the upper-end portion.
[3] The rotation mechanism according to [1] or [2], wherein
   the at least one guide member includes an upper guide member disposed at a position outside the winding area on the extension of the upper-end portion in the circumferential direction, and
   the upper guide member has a downwardly inclined surface configured to guide downward one portion of the transmission member closer to the lower-end portion.
[4] The rotation mechanism according to any one of [1] to [3], wherein the at least one guide member is disposed adjacently to at least one of the upper-end portion and the lower-end portion in the circumferential direction.
[5] An overhead transport vehicle comprising:
   a traveling cart including the first portion; and
   a body section including the second portion and a transfer device attached below the second portion and configured to transfer a transported object, wherein
   the rotation mechanism according to any one of [1] to [4] allows the body section to rotate around the rotation axis with respect to the traveling cart.

### Reference Signs List

1 ... overhead traveling vehicle system (traveling vehicle system)
2 ... overhead traveling vehicle (overhead transport vehicle)
5 ... system controller
8 ... cart controller (control unit)
10 ... body section
12 ... body frame (second portion)
18 ... transfer device
20 ... traveling cart
30 ... traveling unit
33 ... traveling drive motor
35 ... connecting part
40 ... wheel-pivoting mechanism
43 ... steering motor
50 ... cart unit
50a ... cart-frame lower portion (first portion)
52 ... support member (cylindrical member)
52a ... outer circumferential surface
58A ... upper attachment portion
58B ... lower attachment portion
60 ... drive unit
66 ... transmission member
66C ... one portion (closer to the upper-end portion)
66D ... one portion (closer to the lower-end portion)
67A ... upper-end portion
67B ... lower-end portion
70 ... guide member
70A ... upper guide member
70B ... lower guide member
100 ... rail unit
110 ... first rail member
113 ... first support wall
120 ... second rail member
123 ... second support wall
130 ... intersection rail member
140 ... coupling member
200 ... rail assembly
300 ... rotation mechanism
A ... winding area
D1 ... first traveling direction
D2 ... second traveling direction
G ... spacing
H ... hanging member
M ... article
R ... track
R1 ... first rail
R2 ... second rail
R3 ... intersection rail
R1a ... first traveling surface
R2a ... second traveling surface
R3a ... intersection traveling surface

## Claims

1. A rotation mechanism comprising:
a first portion; and
a second portion disposed below the first portion and configured to rotate relatively to the first portion around a rotation axis extending in a vertical direction, wherein
either the first portion or the second portion includes:
a cylindrical member disposed concentrically with the rotation axis; and
a transmission member spirally wound around an outer circumferential surface of the cylindrical member in a winding area exceeding one revolution of the outer circumferential surface, the transmission member including an upper-end portion and a lower-end portion fixed to the cylindrical member,
the other of the first portion and the second portion includes a drive unit configured to feed the transmission member by applying a driving force to the transmission member, and
at least one guide member is provided on the outer circumferential surface of the cylindrical member, at a position outside the winding area on an extension of at least one of the upper-end portion and the lower-end portion in a circumferential direction, and adjacent to the winding area in a direction of the rotation axis.

2. The rotation mechanism according to claim 1, wherein
the at least one guide member includes a lower guide member disposed at a position outside the winding area on the extension of the lower-end portion in the circumferential direction, and
the lower guide member has an upwardly inclined surface configured to guide upward one portion of the transmission member closer to the upper-end portion.

3. The rotation mechanism according to claim 1 or 2, wherein
the at least one guide member includes an upper guide member disposed at a position outside the winding area on the extension of the upper-end portion in the circumferential direction, and
the upper guide member has a downwardly inclined surface configured to guide downward one portion of the transmission member closer to the lower-end portion.

4. The rotation mechanism according to claim 1, wherein the at least one guide member is disposed adjacently to at least one of the upper-end portion and the lower-end portion in the circumferential direction.

5. An overhead transport vehicle comprising:
a traveling cart including the first portion; and
a body section including the second portion and a transfer device attached below the second portion and configured to transfer a transported object, wherein
the rotation mechanism according to claim 1 allows the body section to rotate around the rotation axis with respect to the traveling cart.
